# EUROPEAN PATENT APPLICATION

(11) **EP 4 844 762 A1**
(43) Date of publication of application: **25.11.2026**
(21) Application number: 26177959.9
(22) Date of filing: 11.05.2026
(51) Int. Cl.: G11C 11/16, G11C 8/10, G11C 13/00, G11C 16/08

(54) **DRIVER OF COLUMN DECODER OF NON-VOLATILE MEMORY DEVICE AND METHOD OF OPERATING THEREOF**

(30) Priority: 20.05.2025 US 202519213375
(71) Applicant: STMicroelectronics International N.V., 1228 Plan-les-Ouates, Geneva (CH)
(72) Inventor: MANFRÈ, Davide, I-26025 Pandino (Cremona) (IT); CARISSIMI, Marcella, I-24048 Treviolo (Bergamo) (IT); PERRONI, Maurizio Francesco, I-98054 Furnari (Messina) (IT); DISEGNI, Fabio Enrico Carlo, I-26016 Spino d'Adda (Cremona) (IT)
(74) Representative: Buzzi, Notaro & Antonielli d'Oulx S.p.A.

(57) **Abstract**

A driver circuit (300) for a column decoder of a non-volatile memory is disclosed. The driver circuit includes an output buffer circuit (320). The output buffer circuit (320) includes a first PMOS transistor, a second PMOS transistor, a first NMOS transistor, and a second NMOS transistor. The first PMOS transistor, the second PMOS transistor, the first NMOS transistor, and the second NMOS transistor are coupled in series between a column supply node (340; 410) and a column ground node (340; 420). The driver circuit (300) further includes an elevator circuit (354) coupled between the column supply node (340; 410) and the column ground node (340; 420). The elevator circuit (354) is coupled to a first node (338) and a second node (334) of the output buffer circuit (320). The elevator circuit (354) includes a third PMOS transistor (316) and a fourth PMOS transistor (318) coupled in series between a supply branch node (342) and the first node (338) of the output buffer circuit (320).

## Description

### TECHNICAL FIELD

The present disclosure relates generally to a non-volatile memory device and method of operating thereof, and, in particular embodiments, to a driver of a column decoder of a non-volatile memory device and method of operating thereof.

### BACKGROUND

Non-volatile memory systems are relevant components in a wide range of electronic devices, from consumer electronics to automotive and industrial applications. These memory systems retain stored information even when power is removed, making them valuable for persistent data storage. Among various non-volatile memory technologies, those where memory cell states are changed through controlled current flow, such as Phase Change Memory (PCM), Resistive RAM (RRAM), and Spin-Transfer Torque Magnetic RAM (STT-MRAM), have gained significant attention due to their potential for high density, fast operation, and endurance characteristics.

In these memory architectures, the column decoder plays a major role in selecting specific memory cells within the array for read and write operations. Column decoders typically include driver circuits that generate control signals to activate selection transistors. These driver circuits are requested to operate efficiently during read operations to minimize access times and data retrieval latency, while also supporting the higher voltages required during programming or modify operations. As memory density increases and operating voltages scale with advanced process technologies, designing column decoder circuits that can maintain both high performance and reliability becomes increasingly challenging.

### SUMMARY

In accordance with an embodiment, a driver circuit for a column decoder of a non-volatile memory, the driver circuit includes: an output buffer circuit including a first PMOS transistor, a second PMOS transistor, a first NMOS transistor, and a second NMOS transistor, where the first PMOS transistor, the second PMOS transistor, the first NMOS transistor, and the second NMOS transistor are connected in series between a column supply node and a column ground node; and an elevator circuit connected between the column supply node and the column ground node, the elevator circuit being connected to a first node and a second node of the output buffer circuit, the elevator circuit including a third PMOS transistor and a fourth PMOS transistor connected in series between a supply branch node and the first node of the output buffer circuit. In an embodiment, the elevator circuit further includes: a fifth PMOS transistor connected between the column supply node and the second node of the output buffer circuit; a third NMOS transistor connected between the first node of the output buffer circuit and the second node of the output buffer circuit; and a fourth NMOS transistor connected between the first node of the output buffer circuit and the column ground node. In an embodiment, the elevator circuit further includes a fourth NMOS transistor, a fifth NMOS transistor, and a sixth NMOS transistor connected between the column supply node and a ground node. In an embodiment, the first PMOS transistor and the second PMOS transistor are connected in series between the column supply node and an output node of the output buffer circuit. In an embodiment, the first NMOS transistor and the second NMOS transistor are connected in series between the output node of the output buffer circuit and the column ground node. In an embodiment, an output node of the output buffer circuit is connected to the column decoder. In an embodiment, the output buffer circuit is configured to generate a signal at an output node of the output buffer circuit, the signal corresponding an operation mode of the column decoder.

In accordance with another embodiment, a non-volatile memory device includes: an array of memory cells; a plurality of local column decoders; and a plurality of local driver circuits, where each of the plurality of local driver circuits is coupled to a respective one of the plurality of local column decoders, each of the plurality of local driver circuits including a plurality of driver sub-circuits, each of the plurality of driver sub-circuits including: an output buffer circuit including a first PMOS transistor, a second PMOS transistor, a first NMOS transistor, and a second NMOS transistor, where the first PMOS transistor, the second PMOS transistor, the first NMOS transistor, and the second NMOS transistor are connected in series between a column supply node and a column ground node; and an elevator circuit connected between the column supply node and the column ground node, the elevator circuit being connected to a first node and a second node of the output buffer circuit, the elevator circuit including a third PMOS transistor and a fourth PMOS transistor connected in series between a supply branch node and the first node of the output buffer circuit. In an embodiment, the elevator circuit further includes: a fifth PMOS transistor connected between the column supply node and the second node of the output buffer circuit; a third NMOS transistor connected between the first node of the output buffer circuit and the second node of the output buffer circuit; and a fourth NMOS transistor connected between the first node of the output buffer circuit and the column ground node. In an embodiment, the elevator circuit further includes a fourth NMOS transistor, a fifth NMOS transistor, and a sixth NMOS transistor connected between the column supply node and a ground node. In an embodiment, the first PMOS transistor and the second PMOS transistor are connected in series between the column supply node and an output node of the output buffer circuit. In an embodiment, the first NMOS transistor and the second NMOS transistor are connected in series between the output node of the output buffer circuit and the column ground node. In an embodiment, an output node of the output buffer circuit is connected to a respective column decoder. In an embodiment, the output buffer circuit is configured to generate a signal at an output node of the output buffer circuit, the signal corresponding an operation mode of a respective column decoder.

In accordance with yet another embodiment, a method of operating a non-volatile memory device including an array of memory cells, a plurality of local column decoders, and a plurality of local driver circuits, each of the plurality of local driver circuits including a plurality of driver sub-circuits, each of the plurality of driver sub-circuits including an output buffer circuit and an elevator circuit connected between a column supply node and a column ground node, the output buffer circuit including a first PMOS transistor, a second PMOS transistor, a first NMOS transistor, and a second NMOS transistor, where the first PMOS transistor, the second PMOS transistor, the first NMOS transistor, and the second NMOS transistor are connected in series between the column supply node and the column ground node, and the elevator circuit including a third PMOS transistor and a fourth PMOS transistor connected in series between a supply branch node and a first node of the output buffer circuit, the elevator circuit being connected to the first node and a second node of the output buffer circuit, the method includes: generating a signal at an output node of the output buffer circuit, the signal corresponding an operation mode of a respective column decoder; and providing the signal to a switch of the respective column decoder, the switch being connected to a respective bitline of the respective column decoder. In an embodiment, the signal corresponds to a read mode with the respective bitline being selected. In an embodiment, the signal corresponds to a read mode with the respective bitline deselected. In an embodiment, the signal corresponds to a modify mode with the respective bitline being selected. In an embodiment, the signal corresponds to a modify mode with the respective bitline deselected. In an embodiment, the signal has different voltages for different operation modes.

### BRIEF DESCRIPTION OF THE DRAWINGS

For a more complete understanding of the present disclosure, and the advantages thereof, reference is now made to the following descriptions taken in conjunction with the accompanying drawings, in which:
Figure 1 illustrates a diagram of a non-volatile memory, in accordance with some embodiments;
Figure 2 illustrates a diagram of a local driver circuit coupled to a local column decoder, in accordance with some embodiments;
Figure 3 illustrates a diagram of a driver circuit, in accordance with some embodiments;
Figure 4 illustrates a diagram of an output buffer circuit, in accordance with some embodiments;
Figure 5A illustrates various voltage levels of a driver circuit in a read mode when a respective bitline is selected, in accordance with some embodiments;
Figure 5B illustrates various voltage levels of an output buffer circuit in a read mode when a respective bitline is selected, in accordance with some embodiments;
Figure 6A illustrates various voltage levels of a driver circuit in a read mode when a respective bitline is deselected, in accordance with some embodiments;
Figure 6B illustrates various voltage levels of an output buffer circuit in a read mode when a respective bitline is deselected, in accordance with some embodiments;
Figure 7A illustrates various voltage levels of a driver circuit in a modify mode when a respective bitline is selected, in accordance with some embodiments;
Figure 7B illustrates various voltage levels of an output buffer circuit in a modify mode when a respective bitline is selected, in accordance with some embodiments;
Figure 8A illustrates various voltage levels of a driver circuit in a modify mode when a respective bitline is deselected, in accordance with some embodiments;
Figure 8B illustrates various voltage levels of an output buffer circuit in a modify mode when a respective bitline is deselected, in accordance with some embodiments; and
Figure 9 illustrates a table showing voltage levels of various signals generated by a bank switch during read and modify modes, in accordance with some embodiments.

### DETAILED DESCRIPTION OF ILLUSTRATIVE EMBODIMENTS

The present disclosure relates to a driver circuit for a column decoder of a non-volatile memory, comprising an output buffer circuit coupled to an elevator circuit. In some embodiments, the output buffer circuit includes four transistors (two PMOS transistors and two NMOS transistors) connected in series between a column supply node and a column ground node, forming a cascoded arrangement that generates control signals for column selection. In some embodiments, the elevator circuit connects between the column supply and ground nodes, interfaces with the output buffer at specific nodes, and includes additional PMOS transistors connected in series between a supply branch node and the output buffer circuit. In some embodiments, a bank switch provides appropriate voltage levels to various nodes of the driver circuit based on the operating mode of the non-volatile memory.

During operation, the driver circuit functions in two modes - read mode and modify mode. In read mode, the driver circuit operates with the column supply at approximately 2.2 V and column ground at 0 V, with internal nodes biased to drive the output buffer with a full 1.8 V signal for faster switching, in some embodiments. In an embodiment, when a bitline is deselected, the output node rises to 2.2 V to turn on the selection transistor; when selected, it drops to 0 V. During modify mode, the circuit shifts to higher voltage levels with column supply at 4.8 V and column ground at 2.4 V, while internal nodes are biased to maintain safe voltage differences across all transistors, in some embodiments. In an embodiment, when a bitline is selected, the output node rises to 2.4 V to turn on the selection transistor; when deselected, it rises to 4.8 V.

Various embodiments of the present disclosure provide various benefits. In various embodiments, a driver circuit allows for enhances read operation speed in non-volatile memory systems without compromising device reliability. By incorporating additional transistors (GO2 devices) in the elevator circuit, the design enables the output buffer to be driven with a full 1.8V signal rather than the reduced 1.8V-Vth voltage used in conventional designs. This elimination of the threshold voltage drop results in faster switching times for the column selection transistors, directly improving data throughput during read operations while maintaining the compact area requirements critical for memory systems.

The circuit design also offers versatility by seamlessly transitioning between read and modify modes without sacrificing performance or reliability. During high-voltage modify operations, the circuit automatically adjusts voltage levels at critical nodes to ensure no transistor experiences voltage stress beyond its safe operating limits. This protection mechanism preserves the gate oxide integrity of all devices while still allowing the circuit to handle the elevated voltages (up to 4.8V) needed for programming non-volatile memory cells. The result is a column decoder that delivers superior read performance while maintaining long-term reliability across all operating conditions.

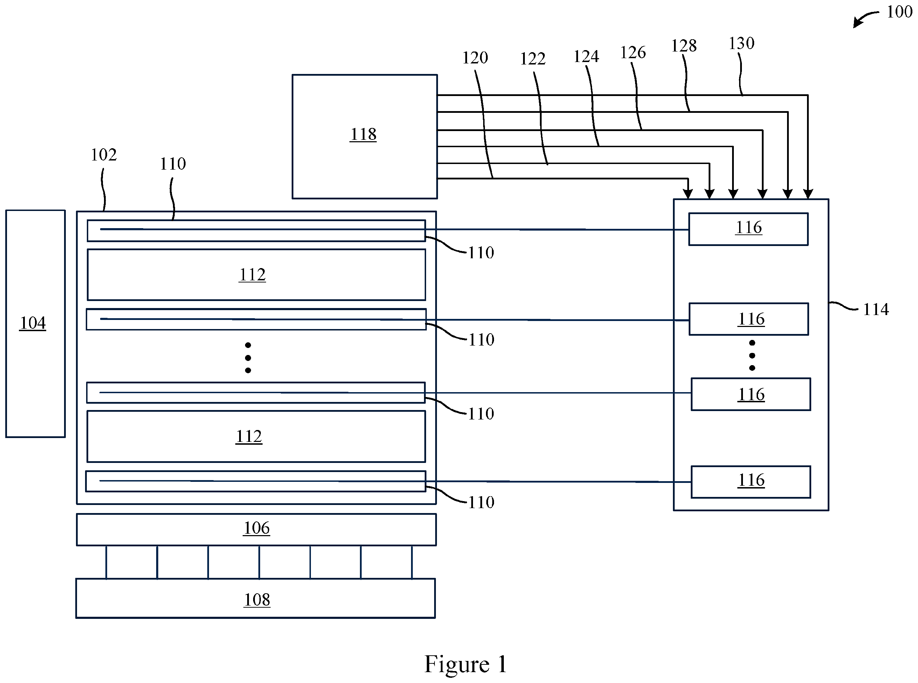

Figure 1 illustrates a schematic view of a non-volatile memory 100, in accordance with some embodiments. In some embodiments, non-volatile memory 100 comprises an array of memory cells 102, which stores data in a non-volatile manner that retains information even when power is removed. The array of memory cells 102 may be organized in rows and columns, with each memory cell capable of storing binary information.

In some embodiments, array of memory cells 102 is coupled to a row decoder 104 and a column decoder 106. Row decoder 104 is responsible for selecting specific rows within the array of memory cells 102 during read and modify operations. When activated, row decoder 104 enables access to all memory cells along a selected row. Column decoder 106 works in conjunction with row decoder 104 to select specific columns, allowing precise addressing of individual memory cells within array of memory cells 102. In some embodiments, a sense amplifier 108 is coupled to the array of memory cells 102 for detecting and amplifying the small voltage differences representing stored data during read operations.

In some embodiments, in addition to column decoder 106 (which may be also referred to as a global column decoder), non-volatile memory 100 further includes a plurality of local column decoders 110 are positioned throughout array of memory cells 102 to interface with groups of memory cells 112, reducing signal path lengths and improving performance.

In some embodiments, a driver circuit 114 is coupled to local column decoders 110. Driver circuit 114 generates and provides the control signals to local column decoders 110 for column selection operations. In some embodiments, driver circuit 114 comprises a plurality of local driver circuits 116, such that each of local driver circuits 116 is connected to a respective one of local column decoders 110.

In some embodiments, non-volatile memory 100 further comprises a bank switch 118 that manages the routing of various signals to driver circuit 114. In some embodiments, the various signals include a column_gnd signal 120, a column_supply signal 122, a Vcasc_pch signal 124 ,a Vcasc_nch signal 126, a Yo_casc_mv signal 128, and a supply_branch signal 130. Column_gnd signal 120 and Column _supply signal 122 provide the reference and supply voltages for driver circuit 114. As described below in greater detail, Vcasc_pch signal 124 and Vcasc_nch signal 126 are used for cascoded transistor configurations within driver circuit 114 to maintain proper voltage levels across devices. Yo_casc_mv signal 128 and supply_branch signal 130 provide additional control functionality for the column selection operations and voltage management. These signals work together to enable efficient read and modify operations within non-volatile memory 100 while protecting the integrity of the circuit components.

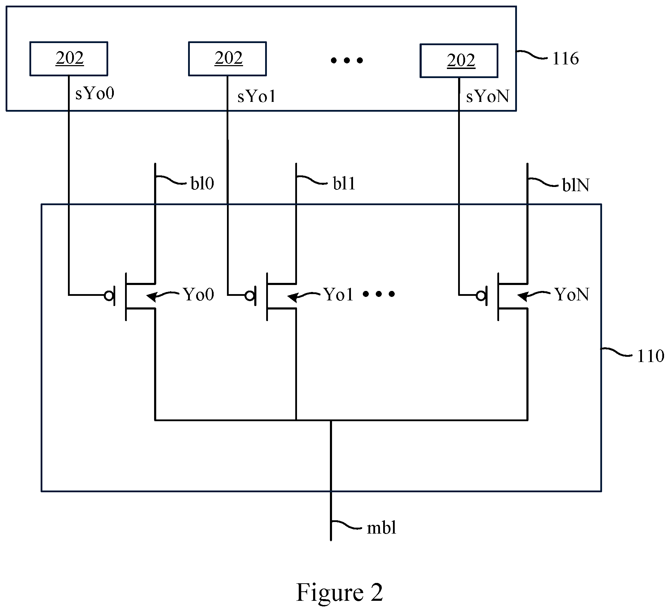

Figure 2 illustrates a schematic view of a local driver circuit 116 coupled to a local column decoder 110, in accordance with some embodiments. In some embodiments, local driver circuit 116 comprises multiple driver sub-circuits 202 that generate the control signals for column selection operations within the non-volatile memory 100. Local column decoder 110 is connected to multiple local bitlines bl0, bl1 through blN, which provide direct paths to individual memory cells within array of memory cells 102. These local bitlines carry the data signals during both read and modify operations, allowing access to specific memory cells when selected. The local column decoder 110 contains selection transistors Yo0, Yo1 through YoN, which function as switches to connect or disconnect specific local bitlines based on the address being accessed.

Each selection transistor (e.g., any of selection transistors Yo0, Yo1 through YoN) is controlled by a corresponding signal (e.g., corresponding one of signals sYo0, sYo1 through sYoN) that is generated by driver sub-circuits 202 within local driver circuit 116. When one of these signals is activated, it turns on its corresponding selection transistor, connecting a specific local bitline (corresponding one of bitlines bl0, bl1 through blN) to the main bitline (mbl).

Driver sub-circuits 202 are designed to provide the appropriate voltage levels to selection transistors Yo0, Yo1 through YoN, ensuring proper operation during both read and modify modes. During read operations, these circuits supply standard logic levels, while during modify operations, they provide the higher voltages needed to program the non-volatile memory cells. This configuration enables efficient memory access while maintaining the integrity of the circuit components, particularly gate oxides of transistors used in driver sub-circuits 202.

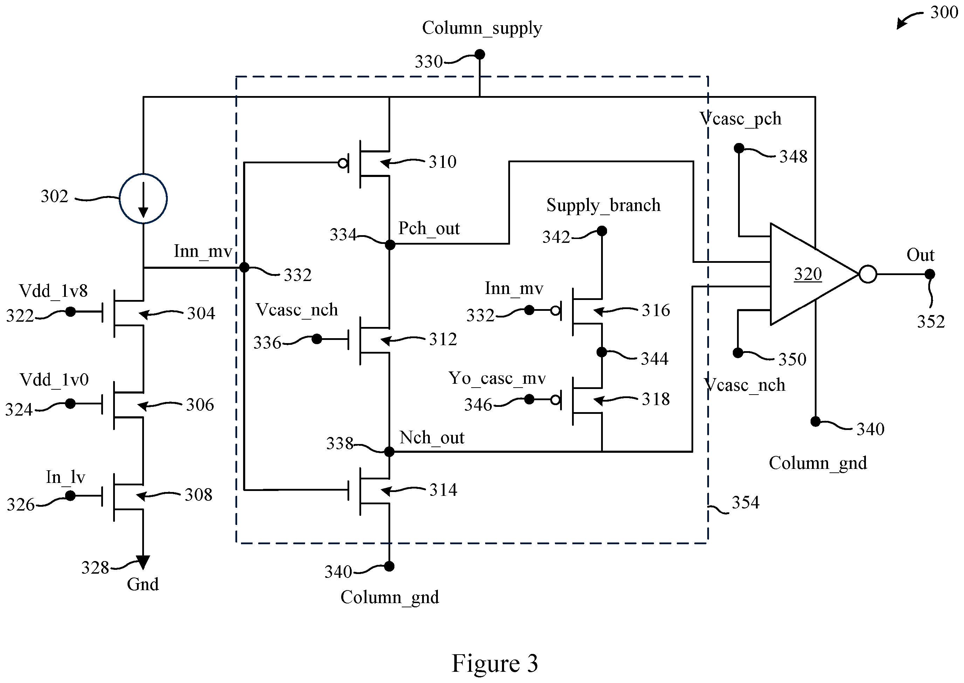

Figure 3 illustrates a schematic view of a driver circuit 300, in accordance with some embodiments. Driver circuit 300 that may be used to implement driver sub-circuits 202 shown in Figure 2. In some embodiments, driver circuit 300 comprises an output buffer circuit 320 coupled to an elevator circuit 354. Elevator circuit 354 may be also referred to as a level shifter. Elevator circuit 354 that shifts voltage levels appropriately to drive output buffer circuit 320.

In some embodiments, a current source 302 supplies a necessary current to drive an output (Out) signal of driver circuit 300. Transistor 304, 306, 308 are connected in series between current source 302 and a ground (Gnd) node 328. In the illustrated embodiment, transistors 304, 306, 308 are NMOS transistors. A gate of transistor 304 is coupled to a Vdd_1v8 node 322, which provides a 1.8 V supply voltage for driver circuit 300. A gate of transistor 306 is coupled to a Vdd_1v0 node 324, which provides a 1.0 V supply voltage for driver circuit 300. A gate of transistor 308 is coupled to an In_lv node 326, which carries the low-voltage input control signal and controls whether the current flows through the circuit, effectively determining the selection or deselection state. The Inn_mv node 332 carries an intermediate voltage that helps control the operation of elevator circuit 354. Transistor 304 and 306 may be collectively referred to as a cascode circuit. Current source 302 and transistors 304, 306, and 308 may be collectively referred to as an input stage.

In some embodiments, elevator circuit 354 may comprise of transistors 310, 312, 314, 316, and 318, arranged to shift voltage levels appropriately between the input stage and output buffer circuit 320. In some embodiments, transistor 310 is a PMOS transistor connected between a column_supply node 330 and a Pch_out node 334, such that a gate of transistor 310 is coupled to Inn_mv node 332. Column_supply node 330 is configured to receive column_supply signal 122 from a bank switch 118 (see Figure 1). In some embodiments, transistor 312 is an NMOS transistor connected between Pch_out node 334 and a Nch_out node 338, such that a gate of transistor 312 is coupled to a Vcasc_nch node 336. In some embodiments, transistor 314 is an NMOS transistor connected between Nch_out node 338 and a column_gnd node 340, such that a gate of transistor 314 is coupled to Inn_mv node 332. Transistor 312 may be also referred to as a cascode circuit. Column_gnd node 340 is configured to receive column_gnd signal 120 from a bank switch 118 (see Figure 1).

In some embodiments, transistors 316 and 318 are PMOS transistors connected in series between a supply_branch node 342 and Nch_out node 338, forming a path for improving signal propagation during read operations. A gate of transistor 316 is coupled to Inn_mv node 332 and a gate of transistor 318 is coupled to a Yo_casc_mv node 346. Supply_branch node 342 is configured to receive supply_branch signal 130 from a bank switch 118 (see Figure 1). Yo_casc_mv node 346 is configured to receive Yo_casc_mv signal 128 from a bank switch 118 (see Figure 1).

Output buffer circuit 320 receives signals from elevator circuit 354 and generates an output (Out) signal at an output node 352. In some embodiments, output buffer circuit 320 is coupled to elevator circuit 354 through Pch_out node 334 and Nch_out node 338 provides Pch_out and Nch_out signals to output buffer circuit 320, respectively. Output buffer circuit 320 may be coupled to a Vcasc_pch node 348 and a Vcasc_nch node 350, which provide cascoded bias voltages for the PMOS and NMOS transistors in the output buffer circuit 320, protecting them from excessive voltage stress during modify operations. Vcasc_pch node 348 is configured to receive Vcasc_pch signal 124 from a bank switch 118 (see Figure 1). Vcasc_nch node 350 is configured to receive Vcasc_nch signal 126 from a bank switch 118 (see Figure 1).

Output buffer circuit 320 may be further coupled to a column_supply node 330 and a column_gnd node 340, which provide supply and reference voltage to output buffer circuit 320. Output buffer circuit 320 generates the output signal at output node 352, which connects to a column decoder (e.g., local column decoder 110 of Figures 1 and 2) to control the selection transistors (e.g., selection transistors Yo0, Yo1 through YoN of Figure 2), enabling or disabling specific bitlines (e.g., bitlines bl0, bl1 through blN of Figure 2) based on the address being accessed and the current operating mode.

In some embodiments, driver circuit 300 is configured to operate in both read and modify modes, with the ability to handle different voltage levels required for each mode. As described below in greater detail, during read operations, driver circuit 300 provides standard logic levels, while during modify operations, driver circuit 300 can supply higher voltages needed for programming non-volatile memory cells while protecting gate oxides of transistors of driver circuit 300 from excessive voltage stress.

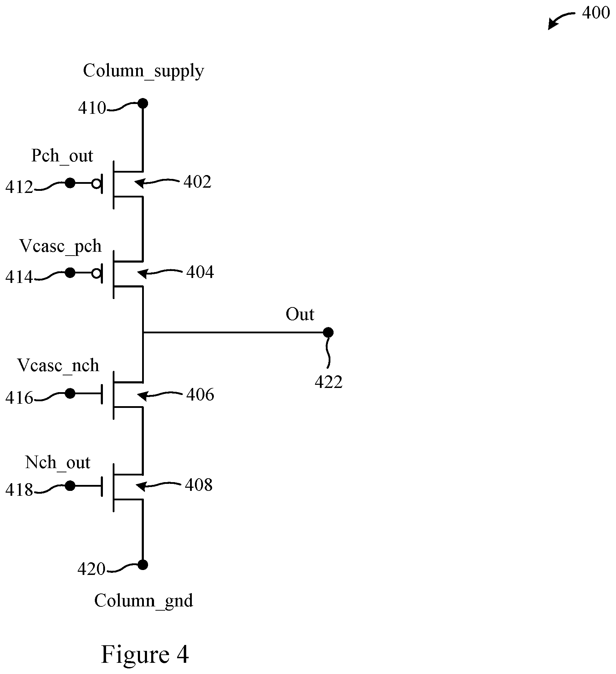

Figure 4 illustrates a schematic view of an output buffer circuit 400, in accordance with some embodiments. Output buffer circuit 400 that may be used to implement the output buffer circuit 320 shown in Figure 3. In the illustrated embodiment, output buffer circuit 400 comprises of four transistors 402, 404, 406, and 408 arranged in a specific configuration to handle both read and modify operations.

Transistors 402 and 404 are PMOS transistors and are connected in series between a column_supply node 410 and an output node 422. A gate of transistor 402 is coupled to a Pch_out node 412, which is configured to provide a Pch_out signal that determines when transistor 402 should turn on to provide a high-level output. A gate of transistor 404 is coupled to a Vcasc_pch node 414, which is configured to provide a Vcasc_pch signal. Transistor 404 serves as a cascode device to protect transistor 402 from excessive voltage stress during modify operations.

Transistors 406 and 408 are NMOS transistors and are connected in series between output node 422 and a column_gnd node 420. A gate of transistor 406 is coupled to a Vcasc_nch node 416, which is configured to provide a Vcasc_nch signal. Transistor 406 serves as a cascode device to protect transistor 408 from excessive voltage stress during modify operations. A gate of transistor 408 is coupled to a Nch_out node 418, which is configured to provide a Nch_out signal that determines when transistor 408 should turn on to provide a low-level output. The output signal generated at the output node 422 drives a respective column selection transistor (e.g., a respective one of selection transistors Yo0, Yo1 through YoN of Figure 2) of a local column decoder 110 (see Figures 1 and 2). During read operations, output buffer circuit 400 provides low voltage levels (0V to 2.2V), while during modify operations, output buffer circuit 400 can handle the high voltage levels (2.4V to 4.8V) needed for programming non-volatile memory cells. The cascode arrangement of the transistors ensures that no single transistor experiences voltage differences beyond its safe operating range, protecting the gate oxide integrity while allowing output buffer circuit 400 to handle the higher voltages needed for modify operations.

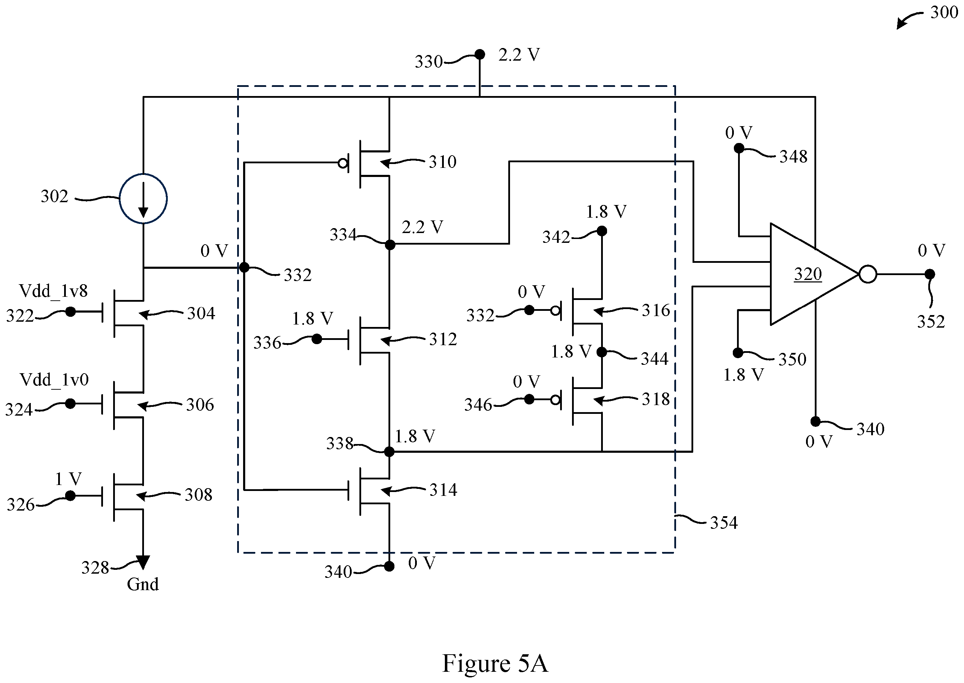

Figure 5A illustrates various voltage levels of a driver circuit 300 in a read mode when a respective bitline (e.g., respective one of bitlines bl0, bl1 through blN of Figure 2) of a local column decoder 110 (see Figures 1 and 2) is selected, in accordance with some embodiments. In this operating mode, the driver circuit 300 is configured to turn on a respective selection transistor (e.g., respective one of transistors Yo0, Yo1, or YoN from Figure 2) to connect the respective local bitline (e.g., respective one of bitlines bl0, bl1 through blN of Figure 2) to the main bitline (e.g., mbl of Figure 2) for reading data from a memory cell.

In this operating mode, Vdd_1v8 node 322 and Vdd_1v0 node 324 are at their nominal voltages of 1.8 V and 1.0 V, respectively. In_lv node 326 is at 1.0 V, indicating an active input signal to select the respective bitline (e.g., respective one of bitlines bl0, bl1 through blN of Figure 2). Column_supply node 330 is at 2.2 V, providing the voltage for the operation of output buffer circuit 320 and elevator circuit 354, while column_gnd node 340 is at 0 V, establishing the ground reference. Inn_mv node 332 is at 0 V, which helps to properly bias the elevator circuit 354. Gnd node 328 is at 0 V. Supply_branch node 342 is at 1.8 V and Yo_casc_mv node 346 is at 0 V. Vcasc_pch node 348 is at 0 V and Vcasc_nch node 350 is at 1.8 V, which ensure that the cascode transistors in output buffer circuit 320 are properly biased. Pch_out node 334 is at 2.2 V, Nch_out node 338 is at 1.8 V, and Node 344 is at 1.8 V.

Output node 352 is at 0 V, which is the voltage level needed to turn on the respective selection transistor (e.g., respective one of transistors Yo0, Yo1, or YoN from Figure 2) in the local column decoder 110, allowing the respective local bitline (e.g., respective one of bitlines bl0, bl1 through blN of Figure 2) to connect to the main bitline (e.g., mbl of Figure 2) for the read operation. This configuration of voltage levels ensures that all transistors operate within their safe voltage limits while providing the necessary control signal for column selection during the read mode.

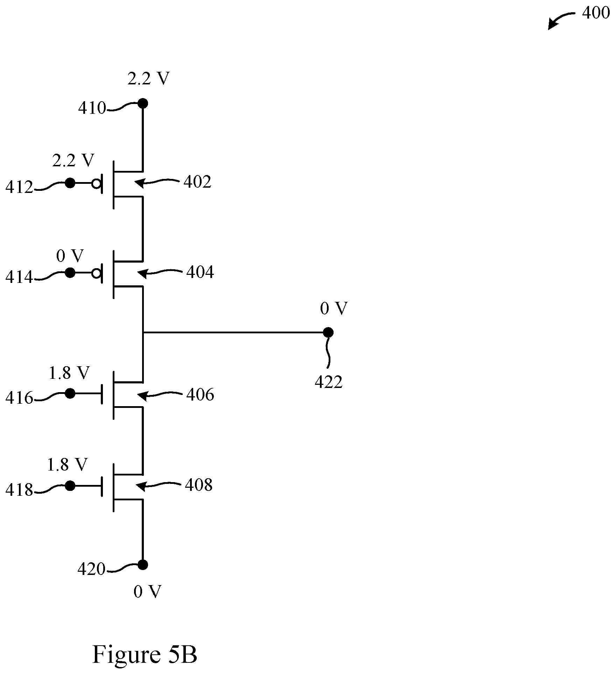

Figure 5B illustrates various voltage levels of an output buffer circuit 400 in a read mode when a respective bitline (e.g., respective one of bitlines bl0, bl1 through blN of Figure 2) of a local column decoder 110 (see Figures 1 and 2) is selected, in accordance with some embodiments. In this operating mode, column_supply node 410 is at 2.2 V, providing the necessary supply voltage for the operation of output buffer circuit 400 during the read mode. Column_gnd node 420 is at 0V, establishing the ground reference for output buffer circuit 400. Pch_out node 412 is at 2.2 V, Vcasc_pch node 414 is at 0 V, Vcasc_nch node 416 is at 1.8 V, Nch_out node 418 is at 1.8 V. These voltage levels deactivate the pull-up circuit (including PMOS transistors 402 and 404), activate the pull-down circuit (including NMOS transistors 406 and 408), and drive output node 422 to 0 V. The voltage levels throughout output buffer circuit 400 are managed to ensure that all transistors operate within their safe voltage limits while providing the necessary functionality for column selection during the read mode.

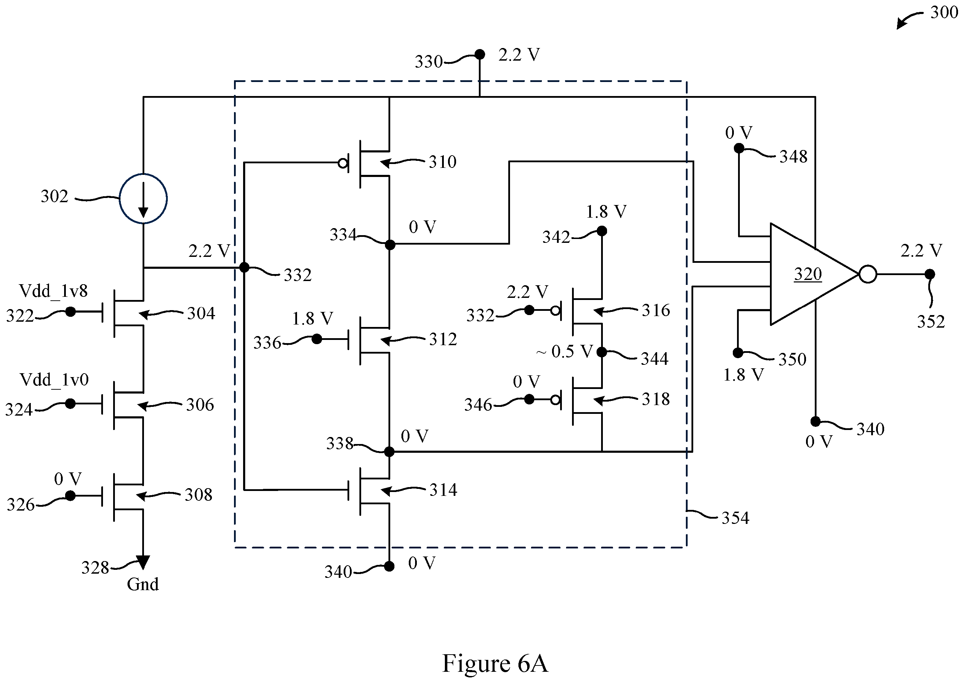

Figure 6A illustrates various voltage levels of a driver circuit 300 in a read mode when a respective bitline (e.g., respective one of bitlines bl0, bl1 through blN of Figure 2) of a local column decoder 110 (see Figures 1 and 2) is deselected, in accordance with some embodiments. In this operating mode, the driver circuit 300 is configured to turn off a respective selection transistor (e.g., respective one of transistors Yo0, Yo1, or YoN from Figure 2) to disconnect the respective local bitline (e.g., respective one of bitlines bl0, bl1 through blN of Figure 2) from the main bitline (e.g., mbl of Figure 2) during a read operation.

In this operating mode, Vdd_1v8 node 322 and Vdd_1v0 node 324 are at their nominal voltages of 1.8 V and 1.0 V, respectively. In_lv node 326 is at 0 V, signaling an inactive input that triggers the deselection of the respective bitline (e.g., respective one of bitlines bl0, bl1 through blN of Figure 2). Column_supply node 330 is at 2.2 V, providing the voltage for the operation of output buffer circuit 320 and elevator circuit 354, while column_gnd node 340 is at 0 V, establishing the ground reference. Inn_mv node 332 is at 2.2 V, which helps to properly bias elevator circuit 354 for the deselection operation. Gnd node 328 is at 0 V. Supply_branch node 342 is at 1.8 V and Yo_casc_mv node 346 is at 0 V. Vcasc_pch node 348 is at 0 V and Vcasc_nch node 350 is at 1.8 V, which ensure that the cascode transistors in output buffer circuit 320 are properly biased. Pch_out node 334 is at 0 V, Nch_out node 338 is at 0 V, and Node 344 is at approximately 0.5 V. Output node 352 is at 2.2 V, which is the voltage level needed to keep the respective selection transistor (e.g., respective one of transistors Yo0, Yo1, or YoN from Figure 2) in the local column decoder 110 turned off, preventing the respective local bitline (e.g., respective one of bitlines bl0, bl1 through blN of Figure 2) from connecting to the main bitline (e.g., mbl of Figure 2) during the read mode. This configuration of voltage levels ensures that all transistors operate within their safe voltage limits while providing the necessary control signal for column selection during the read mode.

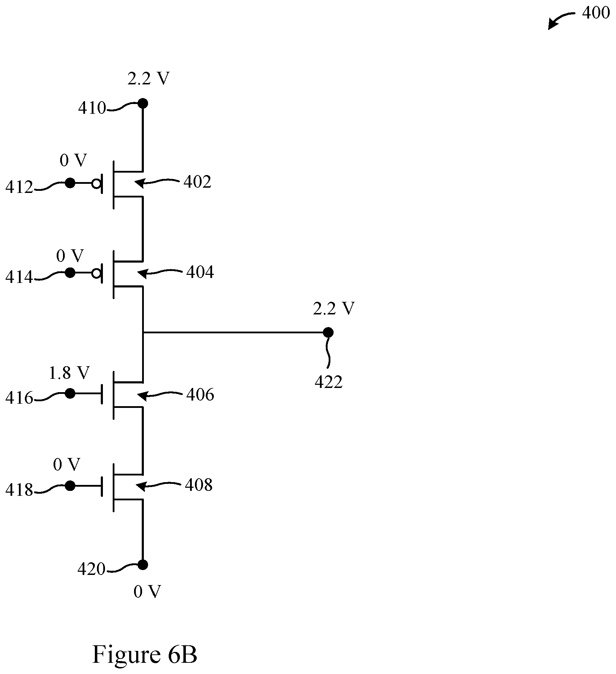

Figure 6B illustrates various voltage levels of an output buffer circuit 400 in a read mode when a respective bitline (e.g., respective one of bitlines bl0, bl1 through blN of Figure 2) of a local column decoder 110 (see Figures 1 and 2) is deselected, in accordance with some embodiments. In this operating mode, column_supply node 410 is at 2.2 V, providing the necessary supply voltage for the operation of output buffer circuit 400 during the read mode. Column_gnd node 420 is at 0V, establishing the ground reference for output buffer circuit 400. Pch_out node 412 is at 0 V, Vcasc_pch node 414 is at 0 V, Vcasc_nch node 416 is at 1.8 V, Nch_out node 418 is at 0 V. These voltage levels activate the pull-up circuit (including PMOS transistors 402 and 404), deactivate the pull-down circuit (including NMOS transistors 406 and 408), and drive output node 422 to 2.2 V. The voltage levels throughout output buffer circuit 400 are managed to ensure that all transistors operate within their safe voltage limits while providing the necessary functionality for column selection during the read mode.

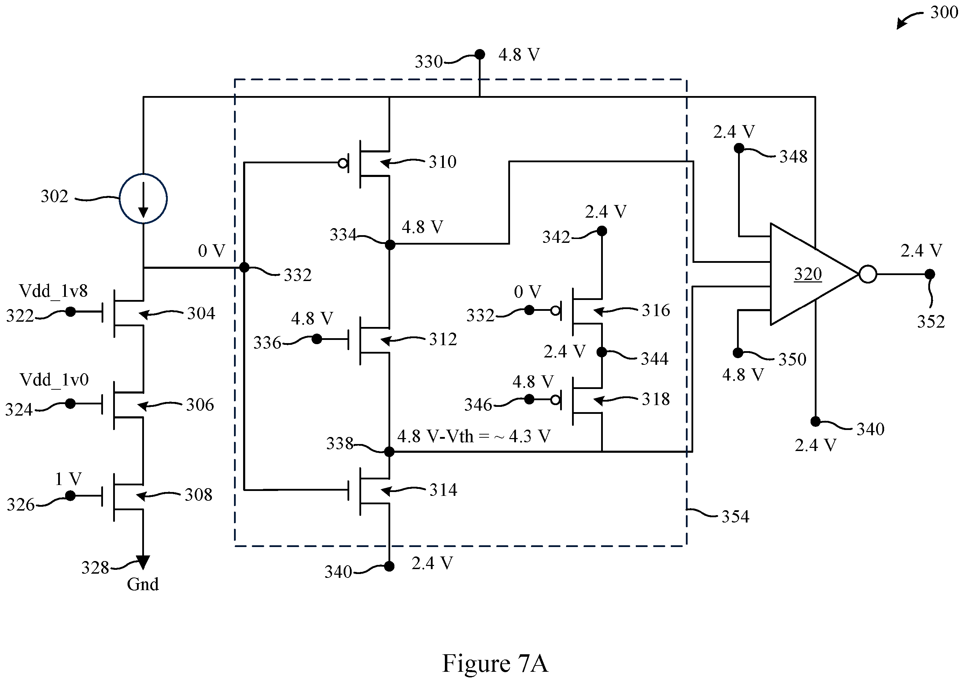

Figure 7A illustrates various voltage levels of a driver circuit 300 in a modify mode when a respective bitline (e.g., respective one of bitlines bl0, bl1 through blN of Figure 2) of a local column decoder 110 (see Figures 1 and 2) is selected, in accordance with some embodiments. In this operating mode, the driver circuit 300 is configured to turn on a respective selection transistor (e.g., respective one of transistors Yo0, Yo1, or YoN from Figure 2) to connect the respective local bitline (e.g., respective one of bitlines bl0, bl1 through blN of Figure 2) to the main bitline (e.g., mbl of Figure 2) for programming or modifying data in a memory cell.

In this operating mode, Vdd_1v8 node 322 and Vdd_1v0 node 324 are at their nominal voltages of 1.8 V and 1.0 V, respectively. In_lv node 326 is at 1.0 V, indicating an active input signal to select the respective bitline (e.g., respective one of bitlines bl0, bl1 through blN of Figure 2). Column_supply node 330 is at 4.8 V, providing the voltage for the operation of output buffer circuit 320 and elevator circuit 354, while column_gnd node 340 is at 2.4 V, establishing the ground reference. Inn_mv node 332 is at 0 V, which helps to properly bias the elevator circuit 354. Gnd node 328 is at 0 V. Supply_branch node 342 is at 2.4 V and Yo_casc_mv node 346 is at 4.8 V, which ensure that a branch including PMOS transistors 316 and 318 is turned off. Vcasc_pch node 348 is at 2.4 V and Vcasc_nch node 350 is at 4.8 V, which ensure that the cascode transistors in output buffer circuit 320 are properly biased. Pch_out node 334 is at 4.8 V, Nch_out node 338 is at 4.8 V-Vth= ~ 4.3 V, and Node 344 is at 2.4 V.

Output node 352 is at 2.4 V, which is the voltage level needed to turn on the respective selection transistor (e.g., respective one of transistors Yo0, Yo1, or YoN from Figure 2) in the local column decoder 110, allowing the respective local bitline (e.g., respective one of bitlines bl0, bl1 through blN of Figure 2) to connect to the main bitline (e.g., mbl of Figure 2) for programming. This configuration of voltage levels ensures that all transistors operate within their safe voltage limits while providing the necessary control signal for column selection during the modify mode.

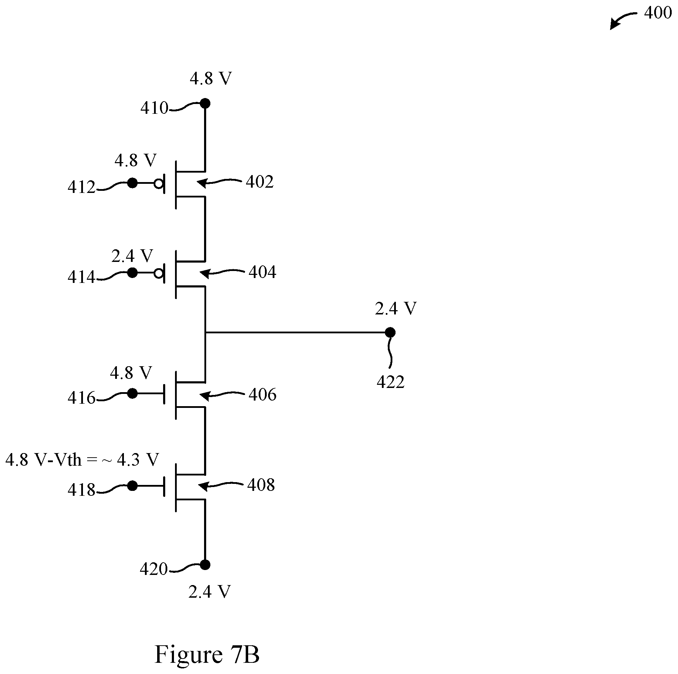

Figure 7B illustrates various voltage levels of an output buffer circuit 400 in a modify mode when a respective bitline (e.g., respective one of bitlines bl0, bl1 through blN of Figure 2) of a local column decoder 110 (see Figures 1 and 2) is selected, in accordance with some embodiments. In this operating mode, column_supply node 410 is at 4.8 V, providing the necessary supply voltage for the operation of output buffer circuit 400 during the modify mode. Column_gnd node 420 is at 2.4V, establishing the ground reference for output buffer circuit 400. Pch_out node 412 is at 4.8 V, Vcasc_pch node 414 is at 2.4 V, Vcasc_nch node 416 is at 4.8 V, Nch_out node 418 is at 4.8 V-Vth= ~ 4.3 V. These voltage levels deactivate the pull-up circuit (including PMOS transistors 402 and 404), activate the pull-down circuit (including NMOS transistors 406 and 408), and drive output node 422 to 2.4 V. The voltage levels throughout output buffer circuit 400 are managed to ensure that all transistors operate within their safe voltage limits while providing the necessary functionality for column selection during the modify mode.

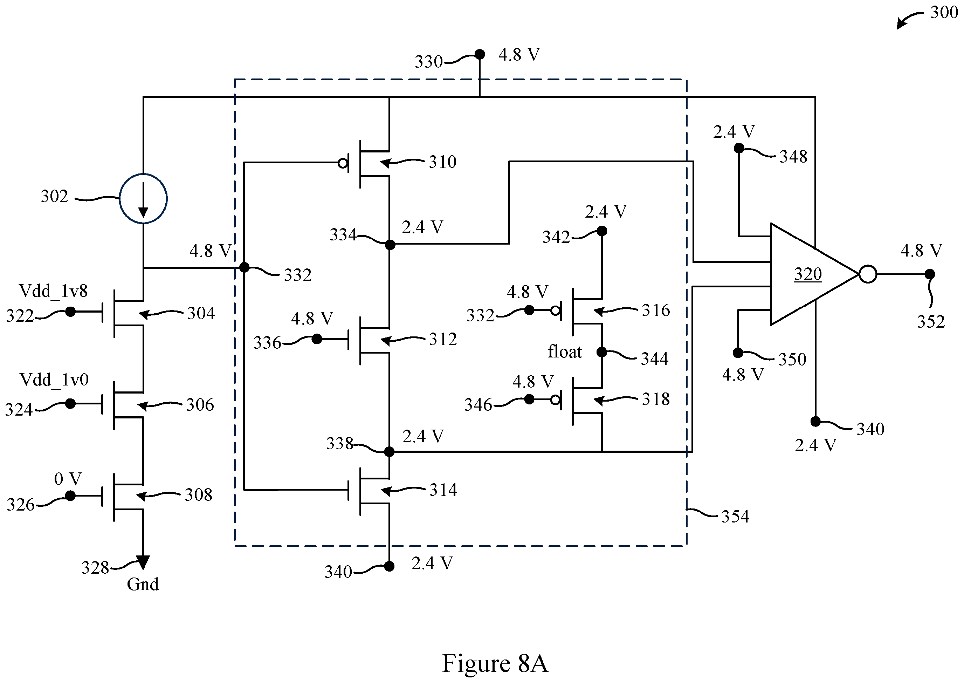

Figure 8A illustrates various voltage levels of a driver circuit 300 in a modify mode when a respective bitline (e.g., respective one of bitlines bl0, bl1 through blN of Figure 2) of a local column decoder 110 (see Figures 1 and 2) is deselected, in accordance with some embodiments. In this operating mode, the driver circuit 300 is configured to turn off a respective selection transistor (e.g., respective one of transistors Yo0, Yo1, or YoN from Figure 2) to disconnect the respective local bitline (e.g., respective one of bitlines bl0, bl1 through blN of Figure 2) from the main bitline (e.g., mbl of Figure 2) during the modify mode.

In this operating mode, Vdd_1v8 node 322 and Vdd_1v0 node 324 are at their nominal voltages of 1.8 V and 1.0 V, respectively. In_lv node 326 is at 0 V, signaling an inactive input that triggers the deselection of the respective bitline (e.g., respective one of bitlines bl0, bl1 through blN of Figure 2). Column_supply node 330 is at 4.8 V, providing the voltage for the operation of output buffer circuit 320 and elevator circuit 354, while column_gnd node 340 is at 2.4 V, establishing the ground reference. Inn_mv node 332 is at 4.8 V, which helps to properly bias elevator circuit 354 for the deselection operation. Gnd node 328 is at 0 V. Supply_branch node 342 is at 2.4 V and Yo_casc_mv node 346 is at 4.8 V, which ensure that a branch including PMOS transistors 316 and 318 is turned off. Vcasc_pch node 348 is at 2.4 V and Vcasc_nch node 350 is at 4.8 V, which ensure that the cascode transistors in output buffer circuit 320 are properly biased. Pch_out node 334 is at 2.4 V and Nch_out node 338 is at 2.4 V.

Output node 352 is at 4.8 V, which is the voltage level needed to keep the respective selection transistor (e.g., respective one of transistors Yo0, Yo1, or YoN from Figure 2) in the local column decoder 110 turned off, preventing the respective local bitline (e.g., respective one of bitlines bl0, bl1 through blN of Figure 2) from connecting to the main bitline (e.g., mbl of Figure 2) during the modify mode. This configuration of voltage levels ensures that all transistors operate within their safe voltage limits while providing the necessary control signal for column selection during the modify mode.

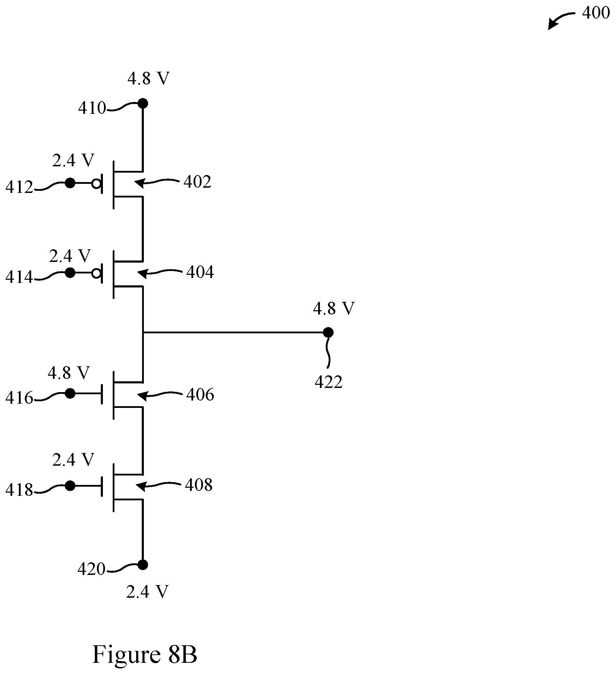

Figure 8B illustrates various voltage levels of an output buffer circuit 400 in a modify mode when a respective bitline (e.g., respective one of bitlines bl0, bl1 through blN of Figure 2) of a local column decoder 110 (see Figures 1 and 2) is deselected, in accordance with some embodiments. In this operating mode, column_supply node 410 is at 4.8 V, providing the necessary supply voltage for the operation of output buffer circuit 400 during the modify mode. Column_gnd node 420 is at 2.4 V, establishing the ground reference for output buffer circuit 400. Pch_out node 412 is at 2.4 V, Vcasc_pch node 414 is at 2.4 V, Vcasc_nch node 416 is at 4.8 V, Nch_out node 418 is at 2.4 V. These voltage levels activate the pull-up circuit (including PMOS transistors 402 and 404), deactivate the pull-down circuit (including NMOS transistors 406 and 408), and drive output node 422 to 4.8 V. The voltage levels throughout output buffer circuit 400 are managed to ensure that all transistors operate within their safe voltage limits while providing the necessary functionality for column selection during the modify mode.

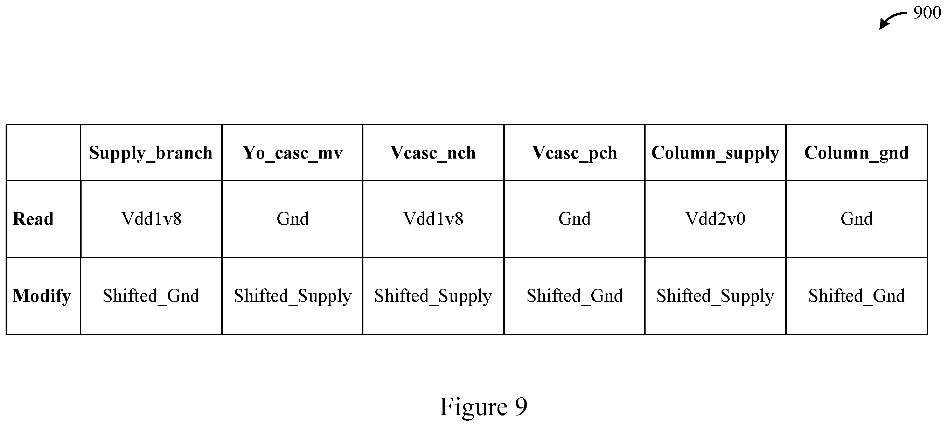

Figure 9 illustrates a table 900 showing voltage levels of various signals generated by a bank switch 118 (see Figure 1) during read and modify modes, in accordance with some embodiments. In the read mode, a voltage of supply_branch signal is set to Vddiv8 (1.8 V), a voltage of Yo_casc_mv signal is set to Gnd (0V), a voltage of Vcasc_nch signal is set to Vddiv8 (1.8V), a voltage of Vcasc_pch is set to Gnd (0 V), a voltage of column_supply is set to Vdd2v0 (2.2 V), and a voltage of column_gnd signal is set to Gnd (0 V).

In the modify mode, a voltage of supply_branch signal is set to Shifted_Gnd, a voltage of Yo_casc_mv signal is set to Shifted_Supply, a voltage of Vcasc_nch signal is set to Shifted_Supply, a voltage of Vcasc_pch is set to Shifted_Gnd, a voltage of column_supply is set to Shifted_Supply, and a voltage of column_gnd signal is set to Shifted_Gnd. In some embodiments, Shifted_Supply is chosen to be 4.8 V, and to Shifted_Gnd is equal to Shifted_Supply/2 = 2.4 V.

The following table summarizes the discussion above:

| | Supply_br anch | Yo_casc_m v | Vcasc_nch | Vcase_pc h | Column_su pply | Column_ gnd |
|---|---|---|---|---|---|---|
| Read | Vddiv8 | Gnd | Vdd1v8 | Gnd | Vdd2v0 | Gnd |
| Modi fy | Shifted_Gn d | Shifted_Su pply | Shifted_Su pply | Shifted_ Gnd | Shifted_Su pply | Shifted_ Gnd |

While this disclosure has been described with reference to illustrative embodiments, this description is not intended to be construed in a limiting sense. Various modifications and combinations of the illustrative embodiments, as well as other embodiments of the disclosure, will be apparent to persons skilled in the art upon reference to the description. It is therefore intended that the appended claims encompass any such modifications or embodiments.

## Claims

1. A driver circuit (300) for at least one column decoder (106, 110) of a non-volatile memory (100), the driver circuit (300) comprising:
an output buffer circuit (320; 400) comprising a first PMOS transistor(402), a second PMOS transistor (404), a first NMOS transistor (406), and a second NMOS transistor (408), wherein the first PMOS transistor (402), the second PMOS transistor (404), the first NMOS transistor (406), and the second NMOS transistor (408) are coupled in series between a column supply node (340; 410) and a column ground node (340; 420); and
an elevator circuit (354) coupled between the column supply node (340; 410) and the column ground node(240), the elevator circuit (354) being coupled to a first node (338) and a second node (334) of the output buffer circuit (320; 400), the elevator circuit (354) comprising a third PMOS transistor (316) and a fourth PMOS transistor (318) coupled in series between a supply branch node (342) and the first node (338) of the output buffer circuit (320; 400).

2. The driver circuit (300) of Claim 1, wherein the elevator circuit (354) further comprises:
a fifth PMOS transistor (310) coupled between the column supply node (340; 410) and the second node (334) of the output buffer circuit (320; 400);
a third NMOS transistor (312) coupled between the first node (338) of the output buffer circuit (320; 400) and the second node (338) of the output buffer circuit (320; 400); and
a fourth NMOS transistor (314) coupled between the first node (338) of the output buffer circuit (320; 400) and the column ground node (340; 420).

3. The driver circuit (300) of Claim 1, wherein the elevator circuit (354) further comprises a fourth NMOS transistor (304), a fifth NMOS transistor (306), and a sixth NMOS transistor (308) coupled between the column supply node (340; 410) and a ground node (328).

4. The driver circuit (300) of Claim 1, wherein:
- the first PMOS transistor (402) and the second PMOS transistor (404) of the output buffer circuit (320; 400); are coupled in series between the column supply node (340; 410) and an output node (352; 422) of the output buffer circuit (320; 400), and/or
- the first NMOS transistor (406) and the second NMOS transistor (408) are coupled in series between the output node (352; 422) of the output buffer circuit (320; 400) and the column ground node (340; 420).

5. The driver circuit (300) of Claim 1, wherein an output node (352; 422) of the output buffer circuit (320; 400) is configured to be coupled to the column decoder (106, 110) of the non-volatile memory (100) and/or wherein the output buffer circuit (320; 400) is configured to generate a signal at an output node (352; 422) of the output buffer circuit (320; 400), the signal corresponding an operation mode of the column decoder (106, 110) of the non-volatile memory (100).

6. A non-volatile memory device (100), comprising:
an array of memory cells (102);
a plurality of local column decoders (110); and
a plurality of local driver circuits (116), wherein each of the driver circuits in the plurality of local driver circuits (116) is coupled to a respective column decoder of the plurality of local column decoders (110), each of the plurality of local driver circuits (116) comprising a plurality of driver sub-circuits (202),
wherein each driver sub-circuit of the plurality of driver sub-circuits (202) comprises:
an output buffer circuit (320; 400) comprising a first PMOS transistor (402), a second PMOS transistor (404), a first NMOS transistor (406), and a second NMOS transistor (408), wherein the first PMOS transistor (402), the second PMOS transistor (404), the first NMOS transistor (406), and the second NMOS transistor (408) are coupled in series between a column supply node (340; 410) and a column ground node (340; 420); and
an elevator circuit (354) coupled between the column supply node (340; 410) and the column ground node (340; 420), the elevator circuit (354) being coupled to a first node (338) and a second node (334) of the output buffer circuit (320; 400), the elevator circuit (354) comprising a third PMOS transistor (316) and a fourth PMOS transistor (318) coupled in series between a supply branch node (342) and the first node (338) of the output buffer circuit (320; 400).

7. The non-volatile memory device (100) of Claim 6, wherein the elevator circuit (354) further comprises:
a fifth PMOS transistor (310) coupled between the column supply node (330; 410) and the second node (334) of the output buffer circuit (320; 400);
a third NMOS transistor (312) coupled between the first node (338) of the output buffer circuit (320; 400) and the second node (334) of the output buffer circuit (320; 400); and
a fourth NMOS transistor (314) coupled between the first node (334) of the output buffer circuit (320; 400) and the column ground node (340).

8. The non-volatile memory device (100) of Claim 6, wherein the elevator circuit (354) further comprises a fourth NMOS transistor (304), a fifth NMOS transistor (306), and a sixth NMOS transistor (308) coupled between the column supply node (340; 410) and a ground node (328).

9. The non-volatile memory device (100) of Claim 6, wherein:
- the first PMOS transistor (402) and the second PMOS transistor (404) are coupled in series between the column supply node (340; 410) and an output node (322; 422) of the output buffer circuit (320; 400), and/or
- the first NMOS transistor (406) and the second NMOS transistor (408) are coupled in series between the output node (352; 422) of the output buffer circuit (320; 400) and the column ground node (340; 420).

10. The non-volatile memory device (100) of Claim 6, wherein an output node (352; 422) of the output buffer circuit (320; 400) is configured to be coupled to a respective column decoder (106, 110), and/or, wherein the output buffer circuit (320; 400) is configured to generate a signal at an output node (352; 422) of the output buffer circuit (320; 400), the signal corresponding an operation mode of a respective column decoder (106, 110).

11. A method of operating a non-volatile memory device (100) comprising an array of memory cells (102), a plurality of local column decoders (110), and a plurality of local driver circuits (116), each of the plurality of local driver circuits (116) comprising a plurality of driver sub-circuits, each driver sub-circuit of the plurality of driver sub-circuits (202) comprising an output buffer circuit (320; 400) and an elevator circuit (354) coupled between a column supply node (340; 410) and a column ground node (340; 420), the output buffer circuit (320; 400) comprising a first PMOS transistor (402), a second PMOS transistor (404), a first NMOS transistor (406), and a second NMOS transistor (408), wherein the first PMOS transistor (402), the second PMOS transistor (404), the first NMOS transistor (406), and the second NMOS transistor (408) are coupled in series between the column supply node (340; 410) and the column ground node (340; 420), and the elevator circuit (354) comprises a third PMOS transistor (316) and a fourth PMOS transistor (318) coupled in series between a supply branch node (342) and a first node (338) of the output buffer circuit (320; 400), the elevator circuit (354) being coupled to the first node (338) and a second node (334) of the output buffer circuit (320; 400), the method comprising:
generating a signal at an output node (352; 422) of the output buffer circuit (320; 400), the signal corresponding an operation mode of a respective column decoder of the plurality of local column decoders (110); and
providing the signal to a switch (118; Yo0, Yo1, ..., YoN) of the respective column decoder of the plurality of local column decoders (110), the switch (Yo0, Yo1, ..., YoN) being coupledcoupled to a respective bitline (blo, bl1, ..., blN) of the respective column decoder of the plurality of local column decoders (110).

12. The method of Claim 11, wherein the signal corresponds to a read mode with the respective bitline (blo, bl1, ..., blN) being selected or deselected.

13. The method of Claim 11, wherein the signal corresponds to a modify mode with the respective bitline (blo, bl1, ..., blN) being selected.

14. The method of Claim 11, wherein the signal corresponds to a modify mode with the respective bitline (blo, bl1, ..., blN) deselected.

15. The method of Claim 11, wherein the signal has different voltages (0 V; 2.2 V; 2.4 V; 4.8 V) for different operation modes.
